# EUROPEAN PATENT SPECIFICATION

(11) **EP 3 126 750 B1**
(45) Date of publication and mention of the grant of the patent: **23.10.2024**
(21) Application number: 15765203.3
(22) Date of filing: 18.03.2015
(51) Int. Cl.: F24F 1/24, H05K 5/02, F24F 1/46, F24F 1/58

(54) **OUTDOOR UNIT OF AN AIR CONDITIONER AND METHOD OF MANUFACTURING THE SAME**
AUSSENEINHEIT EINER KLIMAANLAGE UND VERFAHREN ZUR HERSTELLUNG DAVON
UNITÉ EXTÉRIEURE D'UN CLIMATISEUR ET SON PROCÉDÉ DE FABRICATION

(30) Priority: 18.03.2014 KR 20140031815
(43) Date of publication of application: 08.02.2017
(73) Proprietor: LG Electronics Inc., Seoul 150-721 (KR)
(72) Inventor: KIM, Kakjoong, Seoul 153-802 (KR); JUNG, Jaehwa, Seoul 153-802 (KR); SONG, Chiwoo, Seoul 153-802 (KR)
(74) Representative: Vossius & Partner Patentanwälte Rechtsanwälte mbB
(86) International application number: PCT/KR2015/002620
(87) International publication number: WO 2015/142047

(56) References cited:
- EP-A1- 2 306 101
- EP-A1- 2 660 000
- JP-A- 2010 002 121
- JP-A- 2010 118 606
- KR-A- 20080 095 628
- KR-A- 20110 026 844
- US-A1- 2012 312 046

## Description

### Technical Field

The present invention relates to an outdoor unit of an air conditioner and, more particularly, to an outdoor unit of an air conditioner in which a heat generating element mounted on a printed circuit board is cooled by refrigerant.

### Background Art

In general, an air conditioner is an apparatus that processes suctioned air and supplies the processed air into a building or a room to keep indoor air fresh. The air conditioner is mainly classified as a window type air conditioner or a separate type (or split type) air conditioner.

The window type air conditioner, which has an integrated cooling and radiating function, is directly mounted in a window of a building or a house or in a hole formed through the wall of the building or the house with the aid of a support frame.

The separate type air conditioner includes an indoor unit including an indoor heat exchanger and an indoor blower, an outdoor unit including a compressor, an outdoor heat exchanger, and an outdoor blower, and a refrigerant pipe connected between the indoor unit and the outdoor unit.

An outdoor unit of an air conditioner may include a printed circuit board for controlling various components such as a compressor and an outdoor blower. The printed circuit board may be installed in an electric component box.

An outdoor unit of an air conditioner may introduce outdoor air into an electric component box and then discharge the outdoor air. At this time, the outdoor air may dissipate heat in the electric component box, thus enhancing operation reliability of the electric component box. However, when the interior of the electric component box is air-cooled, efficient temperature management according to temperature variation of outdoor air may not be facilitated.

An outdoor unit of an air conditioner may cool an interior of an electric component box using refrigerant, and may cool an interior of an electric component box using a heat exchanger installed at the electric component box, through which refrigerant passes.

### [Prior Art Document]

### [Patent Document]

Korean Patent Registration No. 10-1324935 B1 (1 Nov. 2013)
US 2012/312046 A1 relates to an air conditioner including a compressor, a condenser, an expansion device, and an evaporator. The air conditioner further includes an electric unit including electric components to operate the air conditioner. A cooling module is disposed at least on a side of the electric unit to dissipate heat generated from the electric unit, and at least a portion of the refrigerant tube supply refrigerant discharged from the evaporator to the cooling module.
EP 2 306 101 A1 relates to a printed-circuit board having a power element and a refrigerant jacket to which the power element is thermally connected, with refrigerant circulating therein used in refrigeration cycle, being provided in an outdoor unit casing.
JP 2010 11 8606 A relates to an installing structure of a cooling member including: a substrate that is electrically bonded with an electrical component; a cooling member making contact with the electrical component; a supporting member that is fixed to the substrate; and a fastening means for fastening the electrical component to the supporting member together with the cooling member.

### Disclosure of Invention

### Technical Problem

Therefore, the present invention has been made in view of the above problems, and it is an object of the present invention to provide an outdoor unit of an air conditioner capable of minimizing material costs of a refrigerant tube for cooling a heat generating element in an electric component box.

### Solution to Problem

The invention is defined by the features of the independent claim.

In accordance with an aspect of the present invention, the above and other objects can be accomplished by the provision of an outdoor unit of an air conditioner, including a printed circuit board on which a heat generating element is mounted, a radiating block which contacts the heat generating element and includes a refrigerant path through which refrigerant passes, and a refrigerant tube connected to the radiating block to communicate with the refrigerant path.

The refrigerant path is formed between the opposite sides of the radiating block.

The refrigerant path may be longitudinally formed in the radiating block.

The refrigerant tube may include a plurality of tube parts which are spaced apart from each other with the refrigerant path being disposed therebetween.

Each tube part may be partially fitted in the refrigerant path.

The refrigerant path may include a plurality of refrigerant paths formed in the radiating block.

The plurality of tube parts may include a return tube part for guiding refrigerant introduced through one of the plurality of refrigerant paths into another one of the plurality of refrigerant paths.

The return tube part may be made of the same material as that of the radiating block.

The plurality of tube parts may include a hybrid coupling tube part composed of a first tube section made of the same material as that of the radiating block and a second tube section made of a different material than the radiating block, and the first tube section may be joined to the radiating block.

The refrigerant path may include a plurality of refrigerant paths formed in the radiating block, and wherein the hybrid coupling tube part may include a plurality of hybrid coupling tube parts joined to the radiating block, wherein one of the plurality of hybrid coupling tube parts may be connected to one of the plurality of refrigerant paths and another one of the plurality of hybrid coupling tube parts may be connected to another one of the plurality of refrigerant paths.

An outdoor unit of an air conditioner according to the present invention includes a printed circuit board on which a heat generating element is mounted, an electric component box in which the printed circuit board is installed, a radiating block made of aluminum-based material, which contacts the heat generating element and includes a refrigerant path through which refrigerant passes, and a plurality of tube parts connected to the radiating block to communicate with the refrigerant path and spaced apart from each other with the refrigerant path being disposed therebetween, wherein the plurality of tube parts include a hybrid coupling tube part composed of a first tube section made of aluminum-based material and communicating with the refrigerant path and a second tube section made of copper-based material and connected to the first tube section.

Each of the plurality of tube parts may be partially fitted in the refrigerant path.

The refrigerant path may include a plurality of refrigerant paths formed in the radiating block.

The plurality of tube parts may include a return tube part made of aluminum-based material for guiding refrigerant introduced through one of the plurality of refrigerant paths into another one of the plurality of refrigerant paths.

The hybrid coupling tube part may include a plurality of hybrid coupling tube parts joined to the radiating block, wherein one of the plurality of hybrid coupling tube parts may be connected to one of the plurality of refrigerant paths and another one of the plurality of hybrid coupling tube parts may be connected to another one of the plurality of refrigerant paths.

### Advantageous Effects of Invention

According to the present invention, material costs of a refrigerant tube can be reduced, and radiation performance can be improved by utilization of the whole surface of the refrigerant path as a surface for heat exchange.

Furthermore, since a radiating block and part of a refrigeration tube are made of aluminum-based material, weight of an outdoor unit can be reduced. In this case, when a copper connecting tube is directly joined to the radiating block, product reliability is enhanced.

### Brief Description of Drawings

The above and other objects, features and other advantages of the present invention will be more clearly understood from the following detailed description taken in conjunction with the accompanying drawings, in which:
FIG. 1 is a perspective view illustrating an embodiment of an outdoor unit of an air conditioner according to the present invention;
FIG. 2 is an exploded perspective view illustrating the embodiment of the outdoor unit of an air conditioner according to the present invention;
FIG. 3 is an enlarged front view of a radiating module of the embodiment of the outdoor unit of an air conditioner according to the present invention;
FIG. 4 is an exploded front view of the radiating module of the embodiment of the outdoor unit of an air conditioner according to the present invention;
FIG. 5 is a transverse cross-sectional view illustrating the radiating module and an electric component box of the embodiment of the outdoor unit of an air conditioner according to the present invention;
FIG. 6 is a longitudinal cross-sectional view illustrating the radiating module and the electric component box of the embodiment of the outdoor unit of an air conditioner according to the present invention; and
FIG. 7 is a flowchart illustrating an embodiment of a method of manufacturing the outdoor unit of the air conditioner according to the present invention.

### Best Mode for Carrying out the Invention

Hereinafter, embodiments of the present invention will be described in detail with respect to the accompanying drawings.

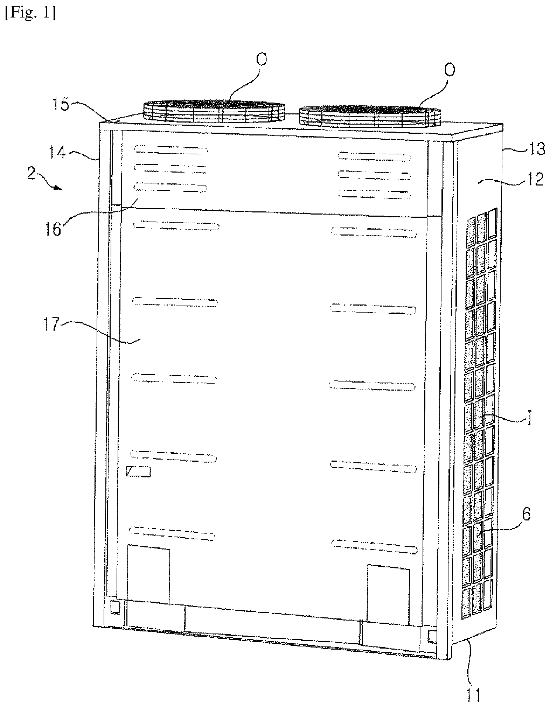

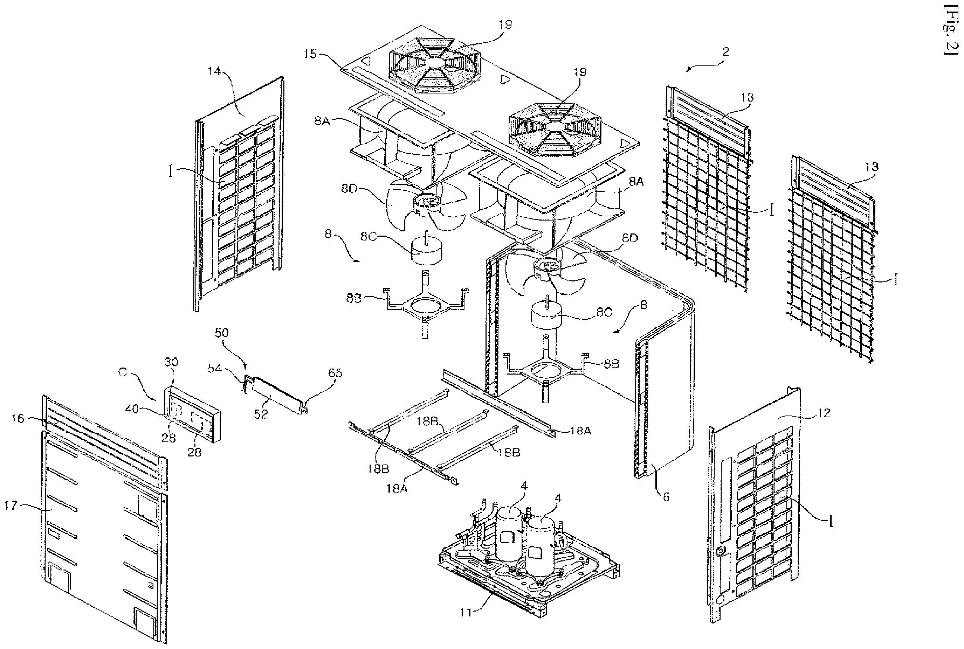

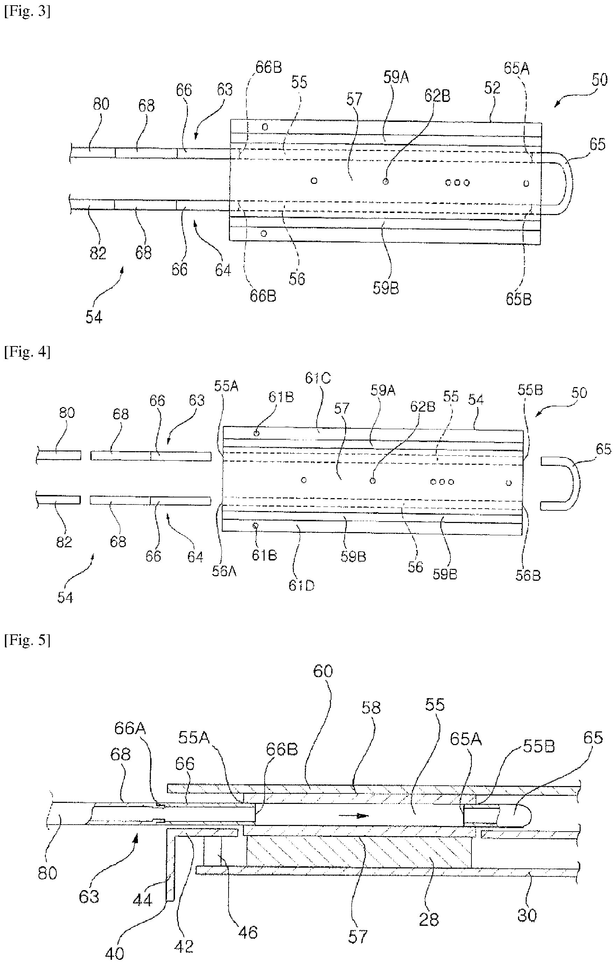

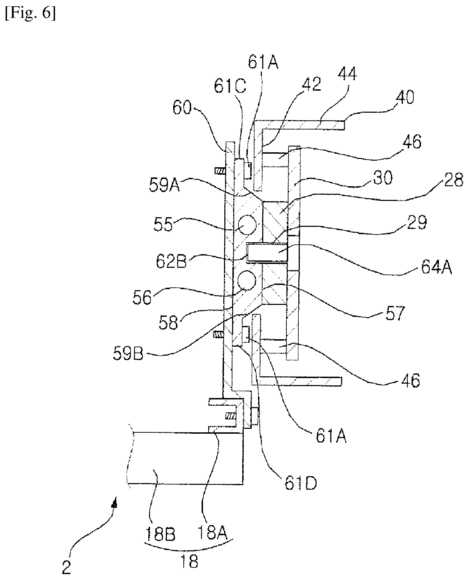

FIG. 1 is a perspective view illustrating an embodiment of an outdoor unit of an air conditioner according to the present invention. FIG. 2 is an exploded perspective view illustrating the embodiment of the outdoor unit of an air conditioner according to the present invention. FIG. 3 is an enlarged front view of a radiating module of the embodiment of the outdoor unit of an air conditioner according to the present invention. FIG. 4 is an exploded front view of the radiating module of the embodiment of the outdoor unit of an air conditioner according to the present invention. FIG. 5 is a transverse cross-sectional view illustrating the radiating module and an electric component box of the embodiment of the outdoor unit of an air conditioner according to the present invention. FIG. 6 is a longitudinal cross-sectional view illustrating the radiating module and the electric component box of the embodiment of the outdoor unit of an air conditioner according to the present invention.

The outdoor unit of the air conditioner may include an outdoor body 2, a compressor 4, an outdoor heat exchanger 6, and an outdoor blower 8. The outdoor unit of the air conditioner may be connected to an indoor unit via a liquid pipe and an air pipe. Refrigerant may pass through an indoor heat exchanger provided in the indoor unit while exchanging heat with indoor air. The air conditioner may include an expansion device for expanding the refrigerant in one of the outdoor unit and the indoor unit. The expansion device may include an electronic expansion valve.

The outdoor body 2 may be provided with air suction ports I through which indoor air is introduced into the outdoor body 2. The outdoor body 2 may further be provided with air discharge ports O through which heat exchanged air is discharged to the outside of the outdoor body 2. The outdoor body 2 may define an appearance of the outdoor unit.

The outdoor body 2 may further include a base, cabinet bodies 12, 13 and 14 installed at the base 11, and a top cover 15 mounted on the cabinet bodies 12, 13 and 14. The outdoor body 2 may further include outdoor unit covers 16 and 17 for opening and closing the outdoor unit. The outdoor body 2 may further include a frame 18.

The cabinet bodies 12, 13 and 14 may be formed with the air suction ports I, and thus may serve as air suction bodies through which outdoor air passes for introduction into the outdoor unit. The air suction ports I may be formed at a plurality of surfaces of the outdoor unit body 2. The cabinet bodies 12, 13 and 14 may be composed of a plurality of bodies. The cabinet bodies 12, 13 and 14 may include the left cabinet body 12 including a left outdoor air suction port formed thereat, the rear cabinet body 13 including a rear outdoor air suction port formed thereat, and the right cabinet body 14 including a right outdoor air suction port formed thereat. The rear cabinet body 13 may be integrally formed with at least one of the left cabinet body 12 and the right cabinet body 14, or may be coupled to at least one of the left cabinet body 12 and the right cabinet body 14 by means of fastening elements such as screws. The cabinet bodies 12, 13 and 14 may be provided at areas facing the outdoor heat exchanger 6 with suction grills at which the air suction ports I are formed. Furthermore, the cabinet bodies 12, 13 and 14 may be made of plates at areas facing the outdoor blower 8.

The top cover 15 may be provided with the air discharge port O. The top cover 15 may serve as a discharge body through which outdoor air passes for discharge to the outside of the outdoor unit. The top cover 15 may be horizontally installed on the cabinet bodies 12, 13 and 14. The top cover 15 may define an upper appearance of the outdoor unit. The outdoor blower 8 may be installed at the top cover 15.

The outdoor unit covers 16 and 17 may be coupled to at least one of the base 11, the cabinet bodies 12, 13 and 14, and the frame 18. The outdoor unit covers 16 and 17 may be coupled or dismantled by a worker when the outdoor unit needs to be serviced. The outdoor unit covers 16 and 17 may be coupled by means of fastening elements such as screws. The outdoor unit covers 16 and 17 may be integrated into one member or may be composed of a plurality of members. The outdoor unit covers 16 and 17 may be installed in such a way as to shield an opening between the left cabinet body 12 and the right cabinet body 14 by means of a single cover or a plurality of covers. The outdoor unit covers 16 and 17 may define a front appearance of the outdoor unit. At least one of the outdoor unit covers 16 and 17 may be disposed to shield the front of the electric component box 40. At least one of the outdoor unit covers 16 and 17 may serve as a service cover 16 for shielding the front of the electric component box 40. When the electric component box 40 needs to be serviced, a worker may take the electric component box 40 out of the outdoor unit after removal of the service cover 16. The electric component box 40 may be taken out of the outdoor unit through an opening between the left cabinet body 12 and the right cabinet body 14 after removal of the service cover 16.

The frame 18 may support the outdoor unit body 2. At least one of components of the outdoor unit may be mounted on the frame 18. The frame 18 may include a vertical frame which is vertically disposed in the outdoor unit. The frame 18 may include a horizontal frame which is horizontally disposed in the outdoor unit. The frame 18 may include a plurality of frames, at least one of which may be disposed between a lower part of the outdoor blower 8 and back surfaces of the outdoor unit covers 16 and 17. The frame 18 may include a transverse frame 18A which extends in a lateral direction. The transverse frame 18A may be disposed between the left cabinet body 12 and the right cabinet body 14. The transverse frame 18A may include a plurality of frames which are disposed between the rear cabinet body 13 and the outdoor unit covers 16 and 17. The frame 18 may include an anteroposterior frame 18B which extends in a front-back direction. The anteroposterior frame 18B may be connected to the transverse frame 18A. The anteroposterior frame 18B may be connected to the plurality of transverse frames. The anteroposterior frame 18B may include a plurality of flames which are disposed between the plurality of transverse frames 18A.

The compressor 4 may compress refrigerant.

The air conditioner may be an air conditioner exclusively for cooling. In this case, refrigerant compressed in the compressor 4 may sequentially pass through the outdoor heat exchanger 6, the expansion device, and an indoor heat exchanger (not shown), and then may be introduced into the compressor 4.

The air conditioner may be a heat pump type air conditioner. In this case, refrigerant compressed in the compressor 4 may sequentially pass through the outdoor heat exchanger 6, the expansion device (not shown), and the indoor heat exchanger (not shown), and may be introduced into the compressor 4, during a cooling operation. Meanwhile, the refrigerant may sequentially pass through the indoor heat exchanger, the expansion device (not shown), and the outdoor heat exchanger 6, and may be introduced into the compressor 4, during a heating operation.

The compressor 4 may be installed at the outdoor unit body 2. The compressor 4 may be installed at the base 11 of the outdoor unit body 2. The compressor 4 may be installed so as to be disposed at a lower position in the outdoor unit. When the outdoor unit covers 16 and 17 are removed, the compressor 4 may be exposed to the outside. When the outdoor unit cover 17, which is disposed at a lower position than the outdoor unit cover 16, is removed, the compressor 4 may be exposed through an opening between the left cabinet body 12 and the right cabinet body 14. The compressor 4 may include a plurality of compressors installed at the outdoor unit body 2. At least one of the plurality of compressors 4 may be a variable capacity compressor or an inverter compressor.

The outdoor heat exchanger 6 may exchange heat between outdoor air and refrigerant. The outdoor heat exchanger 6 may be installed at the outdoor unit body 2. The outdoor heat exchanger 6 may be installed on the base 11 of the outdoor unit body 2. The outdoor heat exchanger 6 may be configured to have a shape which is bent at at least one position. The outdoor heat exchanger 6 may be installed so as to be disposed in a space defined by the cabinet bodies 12, 13 and 14. The outdoor heat exchanger may include a left heat exchanger part facing the left cabinet body 12, a right heat exchanger part facing the right cabinet body 14, and a rear heat exchanger part facing the rear cabinet body 13, wherein the left heat exchanger part and the right heat exchanger part may be connected to each other via the rear heat exchanger part.

The outdoor heat exchanger 6 may include a plurality of outdoor heat exchangers which are spaced apart from one another. The outdoor heat exchanger 6 may include a first heat exchanger at which the left heat exchanger part facing the left cabinet body 13 is bent with respect to the rear heat exchanger part facing the rear cabinet body 13, and a second heat exchanger at which the right heat exchanger part facing the right cabinet body 14 is bent with respect to the rear heat exchanger part facing the rear cabinet body 13.

The outdoor blower 8 may cause outdoor air to flow. The outdoor blower 8 may be installed at the outdoor unit body 2 to introduce outdoor air into the outdoor heat exchanger 6 and to discharge the outdoor air. The outdoor blower 8 may be installed at an upper position in the outdoor unit body 2. The outdoor blower 8 may be installed at the top cover 15 of the outdoor unit body 2. The outdoor blower 8 may draw in air present thereunder and discharge the air upward. The outdoor blower 8 may include a shroud 8A for guiding discharge of outdoor air, a motor 8C, and a fan 8D fitted over a rotating shaft of the motor 8C and rotating therewith. The motor 8C of the outdoor blower 8 may be mounted on the frame 18, or may be mounted on the frame 18 by means of an additional motor mount 8B. The motor 8C may be installed at the motor mount 8B. The motor mount 8B may be coupled to at least one of the shroud 8A, the top cover 15, and the frame 18. The shroud 8A may be coupled to at least one of the top cover 15 and the frame 18. The outdoor blower 8 may include a plurality of outdoor blowers installed at the outdoor unit body 2. The outdoor blower 8 may be disposed such that a portion thereof protrudes upward from the top cover 15. The outdoor unit of the air conditioner may further include a discharge grill 19. The discharge grill 19 is installed at the outdoor blower 8 or the top cover 15 to protect the outdoor blower 8.

The outdoor unit of the air conditioner may include a controller C for controlling the air conditioner. The controller C may be composed of a single controller or a plurality of controllers installed at the outdoor unit of the air conditioner. The controller C may be installed at the outdoor unit of the air conditioner to control various electric components such as the compressor 4 or the outdoor blower 8. The controller C may communicate with the indoor unit of the air conditioner to control various electric components such as an indoor blower (not shown) installed at the indoor unit of the air conditioner. The controller C may include at least one electric component for controlling various electric components installed at the air conditioner. The at least one electric component may include at least one printed circuit board on which at least one electric element is mounted. The at least one electric element may include a heat generating element which generates heat during operation of the air conditioner.

The outdoor unit of the air conditioner may include a printed circuit board 30 on which a heat generating element 28 is mounted, and a radiating module 50 through which refrigerant passes and which is in contact with the heat generating element 28. The radiating module 50 may include a radiating block 52, and a refrigerant tube 54 which is connected to the radiating block 52 and through which refrigerant passes.

The outdoor unit of the air conditioner further includes the electric component box 40 in which the printed circuit board 30 is installed. The heat generating element 28 may be mounted on the printed circuit board 30 to be isolated from a back plate 42 of the electric component box 40. The heat generating element 28 may be mounted on the printed circuit board 30 such that all or a part thereof protrudes rearward.

The printed circuit board 30 may include an invert driving printed circuit board for varying an operating frequency of an electric motor for driving the compressor 4. The printed circuit board 30 may be an inverter driver for controlling an inverter compressor. The inverter driving printed circuit board may be provided with the heat generating element 28 such as an intelligent power module (IPM) which generates a large amount of heat. The printed circuit board 30 may be configured to have a larger size than that of the heat generating element 28.

The electric component box 40 protects various electric components including the heat generating element 28 and the printed circuit board 30. The electric component box 40 is mounted on the outdoor unit body 20. The electric component box 40 is mounted on the outdoor unit body 2 by means of fastening elements such as screws, and may be removed from the outdoor unit body 2 at the time of service. The electric component box 40 may be coupled to at least one of the left cabinet body 12, the right cabinet body 14, the service covers 16 and 17, the frame 18, and the outdoor blower 8 by means of fastening elements such as screws. The electric component box 40 may be installed such that at least a portion thereof is positioned in front of the outdoor blower 8. The electric component box 40 may be open at one side thereof. The electric component box 40 may be configured to have a box shape having one open side. The electric component box 40 has an internal space in which the printed circuit board 30 may be provided. The electric component box 40 may be open at a side thereof facing the outdoor unit covers 16 and 17. The electric component box 40 may include the back plate 42, and a peripheral wall 44 formed at a peripheral edge of the back plate 42. The electric component box 40 may have an internal space defined therein. The printed circuit board 30 may be positioned in the internal space defined by the peripheral wall 44. The printed circuit board 30 may be installed at the back plate 42 of the electric component box 40. Disposed between the printed circuit board 30 and the electric component box 40 may be a spacer 46 for isolating the printed circuit board 30 from the back surface 42 of the electric component box 40. The electric component box 40 may have an opening 47 in which one of the radiating block 52 and the heat generating element 28 is disposed. One of the radiating block 52 and the heat generating element 28 may be disposed to pass through the opening 47.

The radiating module 50 may be connected to a refrigeration cycle circuit including the compressor 4, the outdoor heat exchanger 6, the expansion device, and the indoor heat exchanger. The radiating module 50 may be connected to a lower temperature part of the refrigeration cycle circuit which further includes a higher temperature part in addition to the lower temperature part. Refrigerant in the lower temperature part of the refrigeration cycle circuit may flow into the radiating module 50 and may pass through the radiating module 50. The refrigerant may pass through the radiating module 50 while absorbing heat from the heat generating element 28.

The radiating module 50 may be a refrigerant type cooling module in which at least a portion of the radiating module 50 contacts the heat generating element 28 to absorb heat from the heat generating element 28 in a heat transfer manner while refrigerant cools the heat generating element 28. The refrigerant tube 54 may be connected to a refrigerant pipe between the outdoor heat exchanger 6 and the expansion device, or may be connected to a refrigerant pipe between the expansion device and the indoor heat exchanger.

The radiating block 52 may be provided with refrigerant paths 55 and 56 through which refrigerant passes. When refrigerant passes through the refrigerant paths 55 and 56, the radiating block 52 may directly exchange heat with refrigerant in the refrigerant paths 55 and 56 without an additional heat transfer member or tube. The radiating block 52 may absorb heat from the heat generating element 28 through a contact area contacting the heat generating element 28 and may transfer the heat to refrigerant passing through the refrigerant paths 55 and 56. In other words, the refrigerant and the heat generating element 28 may exchange heat through the radiating block 52. The radiating block 52 may be a single heat exchanger member which exchanges heat between the refrigerant and the heat generation element 28.

The radiating block 52 may be configured to have a plate shape, and may be a radiating plate contacting the heat generating element 28. The refrigerant paths 55 and 56 may be longitudinally formed between one side 57 and the other side 58 of the radiating block 52. The radiating block 52 may be formed with a surface contact area which contacts the heat generating element 28. The radiating block 52 may face the heat generating element 28 at one side 57 thereof. The one side of the radiating block 57, which faces the heat generating element 28, includes the surface contact area which contacts the heat generating element 28. The radiating block 52 may be partially positioned outside the electric component box 40. The radiating block 52 may include the other side 58 positioned outside the electric component box 40. The other side 58 positioned outside the electric component box 40 may be positioned opposite the one side 57 including the surface contact area contacting the heat generating element. The one side 57 and the other side 58 of the radiating block 52 may be composed of respective flat surfaces. The refrigerant paths 55 and 56 may be longitudinally formed in the radiating block 52 between the one side 57 contacting the heat generating element 28 and the other side 58 positioned outside the electric component box 40. The refrigerant paths 55 and 56 may be spaced apart from the one side 57 contacting the heat generating element 28 and the other side 58 positioned outside the electric component box 40. The refrigerant paths 55 and 56 may be longitudinally formed to be parallel to the one side 57 contacting the heat generating element 28 and the other side 58 positioned outside the electric component box 40. The refrigerant paths 55 and 56 may have a smaller diameter than a thickness of the radiating plate 52 as viewed in cross-section perpendicular to a flow direction of refrigerant.

The radiating block 52 may be configured to have a rectangular shape, and may be extended in a lateral or vertical direction. The refrigerant paths 55 and 56 may be longitudinally formed in the radiating block 52. One-side ends 55A and 56A and the other-side ends 55B and 56B of the refrigerant paths 55 and 56 may be open. The radiating block 52 may extend in the lateral direction. The refrigerant paths 55 and 56 may be connected between a left end and a right end of the radiating block 52. The radiating paths 55 and 56 may be elongated holes which are longitudinally formed in the radiating block 52 between the left end and the right end.

The refrigerant paths 55 and 56 may include a plurality of refrigerant paths formed in the radiating block 52. The plurality of refrigerant paths 55 and 56 may be spaced apart from each other. The plurality of refrigerant paths 55 and 56 may be independently formed in the radiating block 52 without merging with each other. The plurality of refrigerant paths 55 and 56 may be formed to be parallel to each other. One refrigerant path 55 of the plurality of refrigerant paths 55 and 56 may be positioned over the other 56. One refrigerant path 55 of the plurality of refrigerant paths 55 and 56 may be disposed close to an upper surface 59A of the radiating block 52, and the other refrigerant path 56 of the plurality of refrigerant paths 55 and 56 may be disposed closer to a lower surface 59B of the radiating block 52. The plurality of refrigerant paths 55 and 56 may be spaced apart from each other between the upper surface 59A and the lower surface 59B of the radiating block 52.

The radiating block 52 may be made of aluminum-based material. In the specification, the aluminum-based material may refer to a single aluminum-based material or an aluminum alloy material. The radiating block may be an aluminum radiating plate which is produced from aluminum through extrusion processing. The aluminum radiating block 52 may be produced at lower cost and may have a lighter weight, compared to a copper radiating block. The radiating module 50 may be partially made of an aluminum-based material at a portion thereof through which refrigerant exchanges heat with the heat generating element 28, and, as such, the radiating module 50 may be produced at lower cost, compared to the case in which the radiating block 52 is made of a copper-based material.

The radiating block 52 may be fixedly positioned at the outdoor unit body 2 by means of fastening elements such as screws or hanging elements such as hooks. The radiating block 52 is fixedly positioned at the outdoor unit body 2 by means of an additional radiating block mount 60. The radiating block mount 60 is fixedly installed at the outdoor unit body 2. The radiating block mount 60 may be installed at the frame 18 of the outdoor unit body 2. Specifically, the radiating block mount 60 may be installed at the horizontal frame 18A of the outdoor unit body 2 by means of fastening elements such as screws or hanging elements such as hooks.

The radiating block 52 may be formed with fastening holes 61B through which fastening elements 61A such as screws pass. The radiating block 52 is provided at an upper side thereof with an upper protrusion 61C, and is provided at a lower side thereof with a lower protrusion 61D. The radiating block 52 may have the fastening holes 61B formed at at least one of the upper protrusion 61C and the lower protrusion 61D of the radiating block 52. The radiating block 52 is coupled to the radiating block mount 60 by attaching the upper protrusion 61C and the lower protrusion 61D of the radiating block 52 to the radiating block mount 60 by screws.

The radiating block 52 is coupled to the heat generating element 28 by means of a fastening element 64A such as a screw. The radiating block 52 may be formed with a fastening hole 62B into which the fastening element 64A such as a screw is screwed. The fastening hole 62B of the radiating block 52 may be formed at a region excluding the refrigerant paths 55 and 56. The fastening hole 62B of the radiating block 52 may include a plurality of fastening holes which are formed between the refrigerant paths 55 and 56. The heat generating element 28 may be formed with a fastening hole 29 through which the fastening element 64A such as a screw passes. Therefore, the fastening element 64A such as a screw may pass through the fastening hole 29 of the heat generating element 28 and then may be screwed into the fastening hole 62B of the radiating block 52.

The refrigerant tube 54 may be connected to the refrigeration cycle circuit in such a manner that one end of the refrigerant tube 54 at which refrigerant is introduced is connected to the lower temperature part of the refrigerant cycle circuit and the other end of the refrigerant tube 54 at which the refrigerant is discharged is connected to the lower temperature part of the refrigerant cycle circuit. The refrigerant tube 54 may be connected to the refrigerant pipe between the outdoor heat exchanger 6 and the expansion device, or may be connected to the refrigerant pipe between the expansion device and the indoor heat exchanger. The refrigerant tube 54 may be connected to the radiating block 52 at a position outside the electric component box 40.

The refrigerant tube 54 may be connected to the radiating block 52 so as to communicate with the refrigerant paths 55 and 56. The refrigerant tube 54 may be partially fitted in the refrigerant paths 55 and 56.

The refrigerant tube 54 includes a plurality of tube parts 63, 64 and 65 which are separated from one another. The plurality of tube parts 63, 64 and 65 each may be partially fitted in the refrigerant paths 55 and 56. The plurality of tube parts 63, 64 and 65 may be disposed spaced apart from one another with the refrigerant paths 55 and 56 being disposed therebetween. The refrigerant paths 55 and 56 may have relatively long non-fitting sections in which the plurality of tube parts 63, 64 and 65 are not fitted, and, as such, material costs of the refrigerant tube may be reduced by portions corresponding to the non-fitting sections in which the plurality of tubes 63, 64 and 65 are not fitted. The refrigerant paths 55 and 56 are preferably sectioned such that a length of the non-fitting section of each refrigerant path 55 or 56 is longer than the total length of the fitting sections in which the plurality of tube parts 63, 64 and 65 are fitted. As the total length of the fitting sections in which the plurality of tube parts 63, 64 and 65 are fitted is increased, material costs may be increased. The total length of the fitting sections of the refrigerant paths 55 and 56 in which the plurality of tube parts 63, 64 and 65 are fitted is preferably less than 20% the total length of the refrigerant paths 55 and 56, and most preferably less than 10% the total length of the refrigerant paths 55 and 56.

The plurality of tube parts 63, 64 and 65 may include heterojunction tube parts 63 and 64. Each of the heterojunction tube parts 63 and 64 may include a first tube section 66 communicating with the corresponding one of the refrigerant paths 55 and 56 and made of the same material as that of the radiating block 52, and a second tube section 68 made of a different material than the radiating block 52. The hybrid coupling tube parts 63 and 64 may be disposed spaced apart from a return tube section 65 (described later) with the refrigerant paths 55 and 56 being disposed therebetween.

The first tube section 66 may be joined to the radiation block 52. The first tube section 66 may be of the same material as that of the radiation block 52. The second tube section 68 may be made of a different material than the radiation block 52. The first tube section 66 may be made of aluminum-based material. The second tube section 68 may be made of copper-based material. In the description, the copper-based material may refer to a single copper-based material and a copper alloy material. The first tube section 66 and the second tube section 68 may be joined to the radiation module 52 after integral conjunction of the first tube section 66 and the second tube section 68. The first tube section 66 made of the same material as that of the radiation block 52 may be joined to the radiation block 52. The first tube section 66 may be joined at one end 66A thereof to the second tube section 68 through welding. The first tube section 66 may be fitted at the other end 66B thereof in the refrigerant paths 55 and 56 to contact the radiation block 52. Since the radiation block 52 and the first tube section 66 are made of the same material, the radiation block 52 and the first tube section 66 may be joined to each other through welding while minimizing corrosion at the contact area therebetween.

The hybrid coupling tube parts 63 and 64 may include a plurality of tube sections joined to the radiation block 52. One hybrid coupling tube part 63 of the plurality of hybrid coupling tube parts 63 and 64 may be connected to one refrigerant path 55 of the plurality of refrigerant paths 55 and 56, and the other hybrid coupling part 64 of the plurality of hybrid coupling tube parts 63 and 64 may be connected to the other refrigerant path 56 of the plurality of refrigerant paths 55 and 56.

The radiation block 52 may be joined to the pair of hybrid coupling tube parts 63 and 64. One of the pair of hybrid coupling tube parts 63 and 64 may be an inlet tube section 63 for guiding refrigerant into one refrigerant path 55 of the radiation block 52, and the other of the pair of hybrid coupling tube parts 63 and 64 may be an outlet tube section 64 for guiding refrigerant flowing from the other refrigerant path 56 of the radiation block 52.

The plurality of tube parts 63, 64 and 65 may include the return tube section 65 for guiding refrigerant introduced through one of the plurality of refrigerant paths 55 and 56 into the other of the plurality of refrigerant paths 55 and 56.

The return tube part 65 may be joined to the radiation block 52. The return tube part 66 may be configured such that an inlet end 65A at which refrigerant is introduced and an outlet end 65B from which the refrigerant flows out are disposed parallel to each other and the section between the inlet end 65A and the outlet end 65B is bent into a U shape. The inlet end 65A of the return tube part 65 may be fitted in one 55 of the refrigerant paths of the radiation block 52, and the outlet end 65B of the return tube part 65 may be fitted in the other refrigerant path 56 of the refrigerant paths. The return tube part 65 may be spaced apart from the heteroconjuction tube parts 63 and 64 with the refrigerant paths 55 and 56 being disposed therebetween. The inlet end 65A of the return tube part 65 may be spaced apart from the inlet side tube part 63 with one refrigerant path 55 of the refrigerant paths 55 and 56 being disposed therebetween, and the outlet end 65B of the return tube part 65 may be spaced apart from the outlet side tube part 64 with the other refrigerant path 56 of the refrigerant paths 55 and 56 being disposed therebetween.

The refrigerant tube 54 may be configured such that the inlet side tube part 63 and the return tube part 65 are connected to each other via the radiation block 52 with a spacing being defined therebetween. Furthermore, the refrigerant tube 54 may be configured such that the outlet side tube part 64 and the return tube part 65 are connected to each other via the radiation block 52 with a spacing being defined therebetween. Accordingly, material costs of the refrigerant tube 54 may be reduced by a portion corresponding to the length between the inlet side tube part 63 and the return tube part 65. Furthermore, material costs of the refrigerant tube 54 may be reduced by a portion corresponding to the length between the outlet side tube part 64 and the return tube part 65.

The return tube part 65 may be welded to the radiation block 52 after the inlet side end 65A and the outlet side end 65B are fitted in the radiation block 52. The return tube part 65 may be made of the same material as that of the radiating block 52. When the radiating block 52 is made of aluminum-based material, the return tube part 65 may also be made of aluminum-based material. Since the radiating block 52 and the return tube 65 are made of the same material, the radiation block 52 and the return tube part 65 may be joined to each other through welding while minimizing corrosion at the contact area therebetween.

When the pair of refrigerant paths 55 and 56 are formed in the radiating block 52, the return tube part 65 may connect the pair of refrigerant paths 55 and 56 to each other. The radiating block 52 may be provided with an even number of refrigerant paths, and one return tube part 65 may be provided for every two refrigerant paths.

The refrigerant tube 54 may further include connecting tube sections 80 and 82 connected to the hybrid coupling tube parts 63 and 64. The connecting tube sections 80 and 82 may be connected to the lower temperature part of the refrigeration cycle circuit. The connecting tube sections 80 and 82 may be connected to a refrigerant pipe between the outdoor heat exchanger 6 and the expansion device, or may be connected to a refrigerant pipe between the expansion device and the indoor heat exchanger. The connecting tube sections may be made of the same material as that of the refrigerant pipe between the outdoor heat exchanger 6 and the expansion device or that of the refrigerant pipe between the expansion device and the indoor heat exchanger. The refrigerant pipe between the outdoor heat exchanger 6 and the expansion device or the refrigerant pipe between the expansion device and the indoor heat exchanger may be made of copper-based material, and the connecting tube sections 80 and 82 may be made of copper-based material. The connecting tube sections 80 and 82 may include a pair of connecting tube sections. One connecting tube section 80 of the pair of connecting tube sections may serve as an inlet side connecting tube section connected to the inlet side tube part 63, and the other connecting tube section 82 of the pair of connecting tube sections may serve as an outlet side connecting tube section connected to the outlet side tube part 64.

Since the second tube section 68 of the inlet side tube part 63 may be joined to the inlet side connecting tube section 80 through welding and may be made of the same copper-based material as that of the inlet side connecting tube section 80, the second tube section 68 may be joined to the inlet side connecting tube section 80 through welding while minimizing corrosion at a contact area therebetween.

Furthermore, since the second tube section 68 of the outlet side tube part 64 may be joined to the outlet side connecting tube section 82 through welding and may be made of the same copper-based material as that of the outlet side connecting tube section 82, the second tube section 68 may be joined to the outlet side connecting tube section 82 through welding while minimizing corrosion at a contact area therebetween.

Operations of the present invention will now be described.

During operation of the air conditioner, the heat generating element 28 and the printed circuit board 30 may control the air conditioner, and the heat generating element 28 generates heat.

Refrigerant passing through the lower temperature part of the refrigeration cycle circuit may be introduced into the refrigerant tube 54. The refrigerant passing through the lower temperature part of the refrigeration cycle circuit may be introduced into the inlet side tube part 63 through the inlet side connecting tube section 80 and then may pass through the inlet side tube part 63. Subsequently, the refrigerant may be introduced into one refrigerant path 55 of the refrigerant paths 55 and 56 of the radiating block 52. The refrigerant may exchange heat with the radiating block 52 to primarily absorb heat from the radiating block 52 while passing through the one refrigerant path 55 of the refrigerant paths 55 and 56. The refrigerant passed through the one refrigerant path 55 of the refrigerant paths 55 and 56 may be introduced into the return tube part 65, and then may be introduced into the other refrigerant path 56 of the refrigerant paths 55 and 56 through the return tube part 65. The refrigerant may exchange heat with the radiating block 52 to secondarily absorb heat from the radiating block 52 while passing through the other 56 of the refrigerant paths 55 and 56. The refrigerant passed through the other refrigerant path 56 of the refrigerant paths 55 and 56 and having an increased temperature may be introduced into the outlet side tube part 64, and then may flow to the lower temperature part of the refrigeration cycle circuit through the outlet side connecting tube section 82.

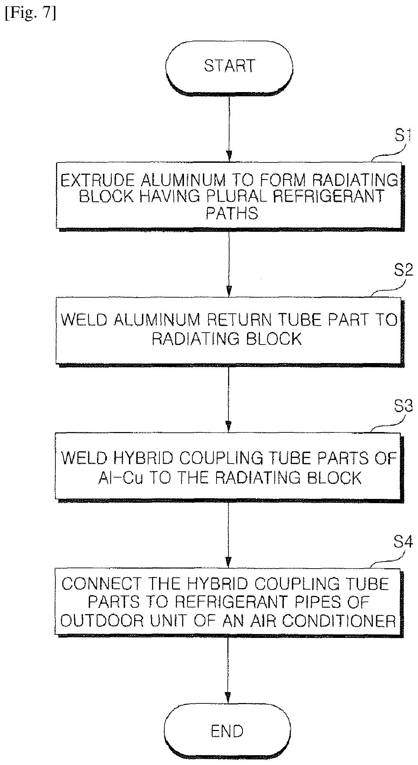

FIG. 7 is a flowchart illustrating an embodiment of a method of manufacturing the outdoor unit of the air conditioner according to the present invention.

The method of manufacturing the outdoor unit of the air conditioner according to the present invention may include operations of manufacturing the radiating module 50 for dissipating heat from the heat generating element 28 and connecting the radiating module 50 to the refrigerant pipe of the outdoor unit of the air conditioner. Hereinafter, the operations of manufacturing the radiating module 50 and connecting the radiating module 50 to the refrigerant pipe of the outdoor unit of the air conditioner will be described.

The method of manufacturing the outdoor unit of the air conditioner includes an operation of extruding the radiating block 52 having the plurality of refrigerant paths 55 and 56 from aluminum (S1: Extrusion of radiating block).

In the extrusion of the radiating block 52, the refrigerant paths 55 and 56 may be longitudinally formed in the radiating block 52. The radiating block 52 may include a pair of refrigerant paths 55 and 56 disposed parallel to each other. The radiating block 52 may be configured into a plate shape having one side 57 and the other side 58 both of which are flat. The radiating block 52 may be configured to have an approximately rectangular shape.

In the method of manufacturing the outdoor unit of the air conditioner, the radiating block 52, which has been prepared through extrusion, may be connected to the return tube part 65 and the hybrid coupling tube parts 63 and 64.

Here, the return tube part 65, which serves as a connecting tube for connecting the plurality of refrigerant paths 55 and 56, may be formed so as to guide refrigerant introduced through one of the pair of refrigerant paths 55 and 56 to the other of the pair of refrigerant paths 55 and 56. The return tube part 65 is preferably made of aluminum-based material for the sake of compatibility with the radiating tube 52 made of aluminum-based material.

The pair of hybrid coupling tube parts 63 and 64 may be welded to the single radiating block 52. One 63 of the pair of hybrid coupling tube parts 63 and 64 may be welded to the radiating block 52 to communicate with one refrigerant path 55, and the other 64 of the pair of hybrid coupling tube parts 63 and 64 may be welded to the radiating block 52 to communicate with the other refrigerant path 56.

The method of manufacturing the outdoor unit of the air conditioner includes an operation of welding the return tube part 65 made of aluminum-based material to the radiating block 52 such that the return tube part 65 communicates with the refrigerant paths 55 and 56 (S2), and an operation of welding the first tube sections 66 of the hybrid coupling tube parts 63 and 64, which are made of aluminum-based material and coupled to the second tube sections 68 made of copper-based material, to the radiating block 52 such that the first tube sections 66 communicate with the refrigerant paths 55 and 56, respectively (S3).

Briefly, the method of manufacturing the outdoor unit of the air conditioner may include the operation S2 of welding the return tube part 65 to the radiating block 52, and the operation S3 of welding the heterojunction tube parts 63 and 64 to the radiating block 52. The method of manufacturing the outdoor unit of the air conditioner may be implemented in such a way that the operation S2 of welding the return tube part 65 to the radiating block 52 is first performed and then the operation S3 of welding the hybrid coupling tube parts 63 and 64 to the radiating block 52 is performed. Conversely, the method of manufacturing the outdoor unit of the air conditioner may be implemented in such a way that the operation S3 of welding the hybrid coupling tube parts 63 and 64 to the radiating block 52 is first performed and then the operation S2 of welding the return tube part 65 to the radiating block 52 is performed. The method of manufacturing the outdoor unit of the air conditioner may, of course, be implemented in such a way that the operation S2 of welding the return tube part 65 to the radiating block 52 and the operation S3 of welding the hybrid coupling tube parts 63 and 64 to the radiating block 52 are concurrently performed. Therefore, the sequence of the operations may be variously selected depending on worker's needs without limitation.

For the purpose of illustration, the operation S2 of welding the return tube part 65 to the radiating block 52 will first be described.

The aluminum return tube part 65 may be fitted in the pair of refrigerant paths 55 and 56 in such a manner that the inlet end 65A of the return tube part 65, at which refrigerant is introduced, is fitted in one refrigerant path 55 of the pair of refrigerant paths 55 and 56 and the outlet end 65B of the return tube part 65, at which the refrigerant flows out, is fitted in the other refrigerant path 56 of the pair of refrigerant paths 55 and 56. After fitting of the return tube part 65 in the refrigerant paths 55 and 56, the return tube part 65 may be welded to the radiating block 52.

Next, the operation S3 of welding the hybrid coupling tube parts 63 and 64 to the radiating block 52 will be described.

One hybrid coupling tube part 63 of the pair of hybrid coupling tube parts 63 and 64 may be welded to the radiating block 52 after being fitted in the one refrigerant path 55, and the other hybrid coupling tube part 64 of the pair of hybrid coupling tube parts 63 and 64 may be welded to the radiating block 52 after being fitted in the other refrigerant path 56.

The method of manufacturing the outdoor unit of the air conditioner may also be implemented in such a manner that the return tube part 65 and the pair of hybrid coupling tube parts 63 and 64 are concurrently welded to the radiating block 52 after the return tube part 65 and the pair of hybrid coupling tube parts 63 and 64 are partially fitted in the radiating block 52.

By joining the return tube part 65 and the hybrid coupling tube parts 63 and 64 to the radiating block 52 in the above-described manner, the return tube part 65, the hybrid coupling tube parts 63 and 64, and the radiating block 52 may be integrated, thus providing the single radiating module 50. The radiating module 50 in which the return tube part 65, the hybrid coupling tube parts 63 and 64, and the radiating block 52 have been incorporated may be installed at the outdoor unit of the air conditioner.

The method of manufacturing the outdoor unit of the air conditioner includes an operation of connecting the second tube sections 68 to the refrigerant pipes of the outdoor unit of the air conditioner (S4). The second tube sections 68 may be connected to the refrigerant pipes of the outdoor unit after being joined to the radiating block 52 via the first tube sections 66. A worker may connect the second tube sections 68 to the refrigerant pipes positioned at the outdoor unit of the refrigeration cycle circuit. The worker may connect the second tube sections 68 to the refrigerant pipes of the lower temperature part of the refrigeration cycle circuit. The worker may connect the second tube sections 68 to the refrigerant pipes between the outdoor heat exchanger 6 and the expansion device or the refrigerant pipes between the expansion device and the indoor heat exchanger. The radiating block 52 may be connected to the refrigerant pipes of the outdoor unit of the air conditioner via the heterojunction tube parts 63 and 64. The refrigerant in the refrigeration cycle circuit may partially flow into and out of the radiating block 52 through the hybrid coupling tube parts 63 and 64.

The worker may mount the electric component box 40 on the outdoor unit of the air conditioner after the radiating block 50 is connected to the refrigeration cycle circuit in the above-described manner. At this time, the worker may mount the electric component box 40 in such a manner that the heat generating element 28 of the printed circuit board 30 installed in the electric component box 40 comes into contact with one side 57 of the radiating block 52. When the electric component box 40 is mounted in this manner, the radiating block 52 may absorb heat from the heat generating element 28 and may transfer the heat to the refrigerant paths 55 and 56.

It will be appreciated that the present invention is not limited to the above embodiments and may adopt a construction in which the refrigerant tube part 54 is connected to a plurality aluminum radiating plates and the refrigerant tube part 54 may further include an aluminum connecting pipe connected to the plurality of radiating plates. The present invention may, of course, be implemented in various ways within the technical scope thereof as defined in the claims.

Various embodiments have been described in the best mode for carrying out the invention.

Although the preferred embodiments of the present invention have been disclosed for illustrative purposes, those skilled in the art will appreciate that various modifications, additions and substitutions are possible, without departing from the scope of the invention as disclosed in the accompanying claims.

## Claims

1. An outdoor unit of an air conditioner, comprising:
a printed circuit board (30) on which a heat generating element (28) is mounted;
an electric component box (40) in which the printed circuit board (30) is mounted;
a radiating block (52) contacting the heat generating element (28) and including a refrigerant path (55, 56) through which refrigerant passes, wherein the radiating block is provided at an upper side thereof with an upper protrusion (61C) and at a lower side thereof with a lower protrusion (61D); and
a refrigerant tube part joined to the radiating block (52) to communicate with the refrigerant path (55, 56);
wherein a radiating block mount (60) is fixedly installed at an outdoor unit body (2), wherein the radiating block (52) is coupled to the radiating block mount (60) by attaching the upper protrusion (61C) and the lower protrusion (61D) to the radiating block mount (60) by screws (61A), and the electric component box (40) is mounted on the outdoor unit body (2) by means of fastening elements such as screws in such a manner that the heat generating element (28) comes into contact with one side (57) of the radiating block (52).

2. The outdoor unit of an air conditioner according to claim 1, wherein the refrigerant tube part includes a plurality of tube parts (63, 64, 65) which are spaced apart from each other with the refrigerant path (55, 56) being disposed therebetween.

3. The outdoor unit of an air conditioner, according to claim 2
wherein the plurality of tube parts (63, 64, 65) include a hybrid coupling tube part (63, 64) composed of a first tube section (66) made of aluminum-based material and communicating with the refrigerant path (55, 56) and a second tube section (68) made of copper-based material and connected to the first tube section.

4. The outdoor unit of an air conditioner according to claim 2 or 3, wherein each of the plurality of tube parts (63, 64, 65) is partially fitted in the refrigerant path (55, 56).

5. The outdoor unit of an air conditioner according to any one of claims 2 to 4, wherein the plurality of tube parts (63, 64, 65) include a return tube part (65) made of aluminum-based material for guiding refrigerant introduced through one of the plurality of refrigerant paths (55, 56) into another one of the plurality of refrigerant paths (55, 56).

6. The outdoor unit of an air conditioner according to any one of claims 3 to 5, wherein the hybrid coupling tube part includes a plurality of hybrid coupling tube parts (63, 64) joined to the radiating block (52),
wherein one of the plurality of hybrid coupling tube parts is connected to one (55) of the plurality of refrigerant paths and another one of the plurality of hybrid coupling tube parts is connected to another one (56) of the plurality of refrigerant paths.

7. The outdoor unit of an air conditioner according to any one of claims 1 to 6, wherein the refrigerant path (55, 56) is formed between opposite sides of the radiating block (52).

8. The outdoor unit of an air conditioner according to any one of claims 1 to 7, wherein the refrigerant path (55, 56) is longitudinally formed in the radiating block (52).

9. The outdoor unit of an air conditioner according to any one of claims 2 to 8, wherein the plurality of tube parts (63, 64, 65) include a return tube part (65) for guiding refrigerant introduced through one (55) of the plurality of refrigerant paths into another one (56) of the plurality of refrigerant pathswherein the return tube part (65) is made of the same material as that of the radiating block (52).

10. The outdoor unit of an air conditioner according to claim 2, wherein the plurality of tube parts (63, 64, 65) include a hybrid coupling tube part (65) composed of a first tube section (66) made of the same material as that of the radiating block (52) and a second tube section (68) made of a different material than the radiating block (52), wherein the first tube section (66) is joined to the radiating block (52).

## Patentansprüche

1. Außeneinheit einer Klimaanlage, die aufweist:
eine Leiterplatte (30), auf der ein Wärmeerzeugungselement (28) angebracht ist;
ein Elektrokomponentenkasten (40), in dem die Leiterplatte (30) montiert ist;
einen Strahlungsblock (52), der das Wärmeerzeugungselement (28) berührt und einen Kältemittelweg (55, 56) enthält, durch den Kältemittel hindurchgeht, wobei der Strahlungsblock an seiner oberen Seite mit einem oberen Vorsprung (61C) und an seiner unteren Seite mit einem unteren Vorsprung (61D) versehen ist; und
einen Kältemittelrohrteil, der mit dem Strahlungsblock (52) verbunden ist, so dass er mit dem Kältemittelweg (55, 56) in Verbindung steht;
wobei eine Strahlungsblockhalterung (60) fest an einem Außeneinheitskörper (2) installiert ist, wobei der Strahlungsblock (52) mit der Strahlungsblockhalterung (60) gekoppelt ist, indem der obere Vorsprung (61C) und der untere Vorsprung (61D) an der Strahlungsblockhalterung (60) durch Schrauben (61A) befestigt sind, und der Elektrokomponentenkasten (40) am Außeneinheitskörper (2) mittels Befestigungselementen, wie z. B. Schrauben, derart angebracht ist, dass das Wärmeerzeugungselement (28) mit einer Seite (57) des Strahlungsblocks (52) in Kontakt kommt.

2. Außeneinheit einer Klimaanlage nach Anspruch 1, wobei der Kältemittelrohrteil mehrere Rohrteile (63, 64, 65) umfasst, die voneinander beabstandet sind, wobei der Kältemittelweg (55, 56) dazwischen angeordnet ist.

3. Außeneinheit einer Klimaanlage nach Anspruch 2, wobei die mehreren Rohrteile (63, 64, 65) einen Hybridkopplungsrohrteil (63, 64) umfassen, das aus einem ersten Rohrabschnitt (66), der aus einem Material auf Aluminiumbasis hergestellt ist und mit dem Kältemittelweg (55, 56) in Verbindung steht, und einem zweiten Rohrabschnitt (68) besteht, der aus einem Material auf Kupferbasis hergestellt ist und mit dem ersten Rohrabschnitt verbunden ist.

4. Außeneinheit einer Klimaanlage nach Anspruch 2 oder 3, wobei jedes der mehreren Rohrteile (63, 64, 65) teilweise in den Kältemittelweg (55, 56) eingesetzt ist.

5. Außeneinheit einer Klimaanlage nach einem der Ansprüche 2 bis 4, wobei die mehreren Rohrteile (63, 64, 65) ein Rücklaufrohrteil (65) aus einem Material auf Aluminiumbasis zum Leiten von durch einen der mehreren Kältemittelwege (55, 56) eingeleitetem Kältemittel in einen anderen der mehreren Kältemittelwege (55, 56) enthalten.

6. Außeneinheit einer Klimaanlage nach einem der Ansprüche 3 bis 5, wobei der Hybridkopplungsrohrteil mehrere Hybridkopplungsrohrteile (63, 64) umfasst, die mit dem Strahlungsblock (52) verbunden sind,
wobei eines der mehreren Hybridkopplungsrohrteile mit einem (55) der mehreren Kältemittelwege verbunden ist und ein anderes der mehreren Hybridkupplungsrohrteile mit einem anderen (56) der mehreren Kältemittelwege verbunden ist.

7. Außeneinheit einer Klimaanlage nach einem der Ansprüche 1 bis 6, wobei der Kältemittelweg (55, 56) zwischen gegenüberliegenden Seiten des Strahlungsblocks (52) ausgebildet ist.

8. Außeneinheit einer Klimaanlage nach einem der Ansprüche 1 bis 7, wobei der Kältemittelweg (55, 56) in Längsrichtung in dem Strahlungsblock (52) ausgebildet ist.

9. Außeneinheit einer Klimaanlage nach einem der Ansprüche 2 bis 8, wobei die mehreren Rohrteile (63, 64, 65) ein Rücklaufrohrteil (65) zum Leiten von durch einen (55) der mehreren Kältemittelwege eingeleiteten Kältemittel in einen anderen (56) der mehreren Kältemittelwege umfassen, wobei der Rücklaufrohrteil (65) aus demselben Material wie das des Strahlungsblocks (52) hergestellt ist.

10. Außeneinheit einer Klimaanlage nach Anspruch 2, wobei die mehreren Rohrteile (63, 64, 65) einen Hybridkopplungsrohrteil (65) umfassen, der aus einem ersten Rohrabschnitt (66), der aus demselben Material wie der Strahlungsblock (52) besteht, und einem zweiten Rohrabschnitt (68) besteht, der aus einem anderen Material als der Strahlungsblock (52) besteht, wobei der erste Rohrabschnitt (66) mit dem Strahlungsblock (52) verbunden ist.

## Revendications

1. Unité extérieure d'un climatiseur, comprenant :
une carte de circuit imprimé (30) sur laquelle est monté un élément de génération de chaleur (28) ;
un boîtier de composants électriques (40) où est monté le circuit imprimé (30) ;
un bloc rayonnant (52) en contact avec l'élément de génération de chaleur (28) et
comprenant un chemin de réfrigérant (55, 56) où passe le réfrigérant, ledit bloc rayonnant étant pourvu d'une saillie supérieure (61C) sur son côté supérieur et d'une saillie inférieure (61D) sur son côté inférieur ; et
une partie de tube réfrigérant reliée au bloc rayonnant (52) de manière à communiquer avec le chemin de réfrigérant (55, 56) ;
où un support de bloc rayonnant (60) est installé de manière fixe sur un corps d'unité extérieure (2), où le bloc rayonnant (52) est raccordé au support de bloc rayonnant (60) par fixation de la saillie supérieure (61C) et de la saillie inférieure (61D) au support de bloc rayonnant (60) au moyen de vis (61A), et le boîtier de composants électriques (40) est monté sur le corps d'unité extérieure (2) au moyen d'éléments de fixation tels que des vis, de sorte que l'élément de génération de chaleur (28) entre en contact avec un côté (57) du bloc rayonnant (52).

2. Unité extérieure d'un climatiseur selon la revendication 1, où la partie de tube réfrigérant comprend une pluralité de parties de tube (63, 64, 65) espacées les unes des autres, le chemin de réfrigérant (55, 56) étant intercalé.

3. Unité extérieure d'un climatiseur selon la revendication 2, où la pluralité de parties de tube (63, 64, 65) comprend une partie de tube de raccord hybride (63, 64) composée d'une première section de tube (66) constituée d'un matériau à base d'aluminium et communiquant avec le chemin de réfrigérant (55, 56), et d'une deuxième section de tube (68) constituée d'un matériau à base de cuivre et raccordée à la première section de tube.

4. Unité extérieure d'un climatiseur selon la revendication 2 ou la revendication 3, où chacune des parties de tube de la pluralité de parties de tube (63, 64, 65) est ajustée en partie dans le chemin de réfrigérant (55, 56).

5. Unité extérieure d'un climatiseur selon l'une des revendications 2 à 4, où la pluralité de parties de tube (63, 64, 65) comprend une partie de tube de retour (65) constituée d'un matériau à base d'aluminium pour conduire le réfrigérant introduit par un chemin de la pluralité de chemins de réfrigérant (55, 56) vers un autre chemin de la pluralité de chemins de réfrigérant (55, 56).

6. Unité extérieure d'un climatiseur selon l'une des revendications 3 à 5, où la partie de tube de raccord hybride comprend une pluralité de parties de tube de raccord hybride (63, 64) reliées au bloc rayonnant (52),
où une partie de tube de la pluralité de parties de tube de raccord hybride est reliée à un chemin (55) de la pluralité de chemins de réfrigérant et une autre partie de tube de la pluralité de parties de tube de raccord hybride est reliée à un autre chemin (56) de la pluralité de chemins de réfrigérant.

7. Unité extérieure d'un climatiseur selon l'une des revendications 1 à 6, où le chemin de réfrigérant (55, 56) est formé entre des côtés opposés du bloc rayonnant (52).

8. Unité extérieure d'un climatiseur selon l'une des revendications 1 à 7, où le chemin de réfrigérant (55, 56) est formé longitudinalement dans le bloc rayonnant (52).

9. Unité extérieure d'un climatiseur selon l'une des revendications 2 à 8, où la pluralité de parties de tube (63, 64, 65) comprend une partie de tube de retour (65) pour conduire le réfrigérant introduit par un chemin (55) de la pluralité de chemins de réfrigérant vers un autre chemin (56) de la pluralité de chemins de réfrigérant, la partie de tube de retour (65) étant constituée du même matériau que le bloc rayonnant (52).

10. Unité extérieure d'un climatiseur selon la revendication 2, où la pluralité de parties de tube (63, 64, 65) comprend une partie de tube de raccord hybride (65) composée d'une première section de tube (66) constituée du même matériau que le bloc rayonnant (52) et d'une deuxième section de tube (68) constituée d'un matériau différent de celui du bloc rayonnant (52), la première section de tube (66) étant reliée au bloc rayonnant (52).
